# EUROPÄISCHE PATENTSCHRIFT

(11) **EP 1 855 317 B1**
(45) Veröffentlichungstag und Bekanntmachung des Hinweises auf die Patenterteilung: **02.11.2011**
(21) Anmeldenummer: 07008722.6
(22) Anmeldetag: 28.04.2007
(51) Int. Cl.: H01L 23/34, F24H 3/06

(54) **Heizvorrichtung für elektronische Bauelemente in militärischen Fahrzeugen, insbesondere Kampfpanzern**
Heating device for electronic components in military vehicles, in particular tanks
Dispositif de chauffage pour composant électronique dans des véhicules militaires, en particulier des tanks de combat

(30) Priorität: 10.05.2006 DE 202006007436 U
(43) Veröffentlichungstag der Anmeldung: 14.11.2007
(73) Patentinhaber: Krauss-Maffei Wegmann GmbH & Co. KG, 80997 München (DE)
(72) Erfinder: Föhst, Stefan, 34376 Immenhausen (DE)
(74) Vertreter: Feder Walter Ebert

(56) Entgegenhaltungen:
- DE-A1- 19 604 218
- DE-U1- 8 307 274
- US-A- 5 915 466

## Beschreibung

Die Erfindung betrifft eine Heizvorrichtung für elektronische Bauelemente in militärischen Fahrzeugen, insbesondere Kampfpanzern.

Eine Heizvorrichtung für elektronische Bauelemente ist beispielsweise aus der deutschen Gebrauchsmusterschrift DE 83 07 274 U bekannt.

Es bestehen Vorschriften, nach denen militärische Fahrzeuge, insbesondere Kampfpanzer, so ausgelegt sein müssen, dass sie bis zu einer Temperatur von - 46° C funktionsfähig sind. Da in derartigen Fahrzeugen angeordnete elektronische Geräte im allgemeinen so ausgelegt sind, dass sie nur bis zu einer Temperatur von - 35° C abgekühlt werden dürfen, ist es notwendig, Möglichkeiten zu schaffen, elektronische Bauelemente innerhalb eines Kampfpanzers so zu beheizen, dass die Temperatur von - 35° C nicht unterschritten wird.

Der Erfindung liegt die Aufgabe zugrunde, eine einfach aufgebaute, wenig Raum beanspruchende und zuverlässig funktionierende, Heizvorrichtung für elektronische Bauelemente in militärischen Fahrzeugen, insbesondere Kampfpanzern, zu schaffen, mit der die gegebenenfalls notwendige Beheizung durchgeführt werden kann. Da in militärischen Fahrzeugen, insbesondere Kampfpanzern, im allgemeinen sehr wenig Bauraum zur Verfügung steht, ist es notwendig, die Heizvorrichtung in einer einfachen, platzsparenden, Weise auszuführen.

Die Lösung dieser Aufgabe besteht erfindungsgemäß mit den Merkmalen aus dem kennzeichnenden Teil des Patentanspruchs 1. Vorteilhafte Weiterbildungen der Erfindung sind in den abhängigen Ansprüchen beschrieben.

Ein Grundgedanke der Erfindung besteht darin, in einer einfachen Konstruktion einen Stiftkühlkörper, wie er aus dem Prozessorbereich an sich bekannt ist, zu beheizen und die erwärmte Luft mittels eines einfach aufgebauten Axial-Lüfters abzuführen. Es hat sich gezeigt, dass die erfindungsgemäße Heizvorrichtung sich sehr einfach und kompakt, insbesondere sehr flach aufbauen läßt und eine sichere Beheizung ermöglicht.

Im folgenden wird anhand der beigefügten Zeichnung ein Ausführungsbeispiel für eine Heizvorrichtung nach der Erfindung näher erläutert.

In der Zeichnung zeigen:
- Fig. 1: eine Heizvorrichtung in einer Ansicht von unten;
- Fig. 2: die Heizvorrichtung nach Fig. 1 in einer Ansicht auf die kürzere Schmalseite;
- Fig. 3: die Heizvorrichtung nach Fig. 1 in einer Ansicht auf die längere Schmalseite.
- Fig. 4: die Heizvorrichtung nach Fig. 1 bis 3 in einer Ansicht von oben.

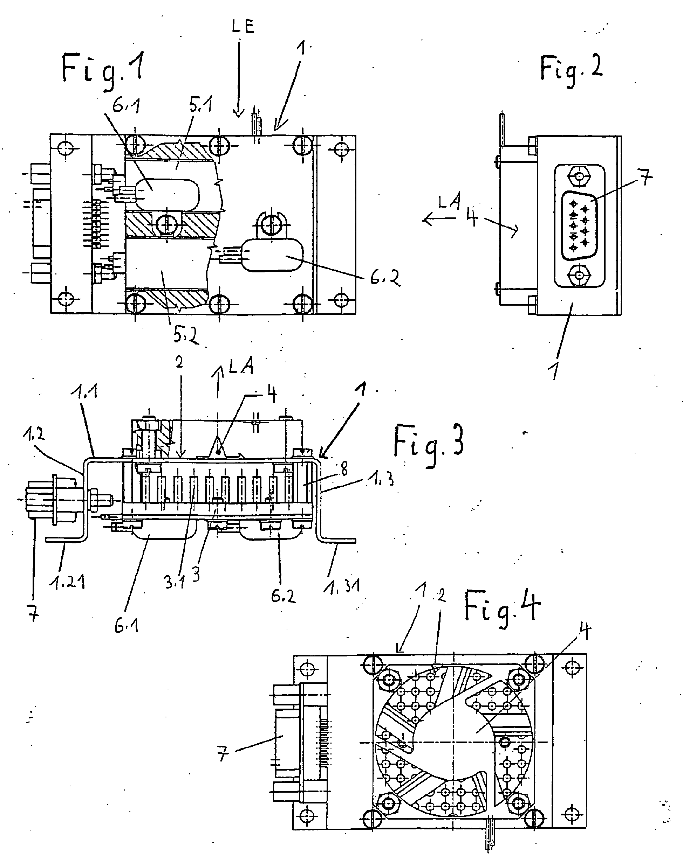

Die in den Figuren 1 bis 4 dargestellte Heizvorrichtung besitzt ein flaches Gehäuse 1 mit im wesentlichen rechteckigem Grundriß, das als an der Unterseite sowie den beiden längeren Schmalseite offenes U-förmiges Profilstück ausgebildet ist, mit einer der Basis des U entsprechenden Oberseite 1.1 sowie zwei Schenkeln 1.2 und 1.3 an den kürzeren Schmalseiten, die an ihren unteren Enden flanschartige Umbiegungen 1.21 und 1.31 aufweisen, über die das Gehäuse mittels Schraubverbindungen auf einer Unterlage in einem nicht dargestellten Fahrzeug befestigt werden kann.

An der Oberseite 1.1 weist das Gehäuse 1 eine in Fig. 4 sichtbare Luftaustrittsöffnung 2 auf.

Im Gehäuse ist ein metallischer Kühlkörper angeordnet mit einer Platte 3, an deren der Gehäuseoberseite zugewandten Oberfläche Stifte 3.1 zur Vergrößerung der Oberfläche angeordnet sind. Der Kühlkörper ist über Schraubverbindungen 8 im Gehäuse 1 aufgehängt.

An der Unterseite der Platte 3 des Kühlkörpers sind Widerstands-Heizfolien 5.1 und 5.2 angeordnet, mittels derer die Platte 3 beheizbar ist. An der Oberseite des Gehäuses 1 ist ein Axial-Lüfter 4 in der Luftaustrittsöffnung 2 angeordnet. Der Axial-Lüfter 4 saugt die Luft aus dem Gehäuse 1 an, die in Pfeilrichtung LE durch die offenen Seitenwände des Gehäuses einströmt und dann beheizt in Pfeilrichtung LA nach außen abgegeben wird.

An der Unterseite der Platte 3 sind weiterhin zwei temperaturgesteuerte Schaltelemente 6.1 und 6.2 angeordnet, mit denen das Ein- und Ausschalten der Vorrichtung gesteuert wird. An dem einen Schenkel 1.2 des Gehäuses 1 ist ein elektrischer Anschlußstecker 7 befestigt, an den die Widerstands-Heizfolien 5.1, 5.2, die Schaltelemente 6.1 und 6.2 und der Axial-Lüfter 4 angeschlossen sind und über den sie mit nicht dargestellten Mitteln zur Zuführung elektrischer Energie und zur Zu- und Abführung von Signalen angeschlossen sind.

## Patentansprüche

1. Heizvorrichtung für elektronische Bauelemente in militärischen Fahrzeugen, insbesondere Kampfpanzern, mit einem flachen Gehäuse (1) mit einer Lufteintrittsöffnung in mindestens einer der schmalen Seitenwände und einer Luftaustrittsöffnung (2) an der Oberseite (1.1), wobei im Gehäuse (1) ein metallischer Kühlkörper angeordnet ist, bestehend aus einer Platte (3), die an ihrer der Oberseite (1.1) des Gehäuses (1) zugewandten Oberfläche mit Rippen oder Stiften (3.1) versehen ist, während sie an der von der Oberseite (1.1) abgewandten Oberfläche mit mindestens einem Heizelement (5.1, 5.2) in Kontakt ist und an der Oberseite (1.1) des Gehäuses (1) in oder vor der Luftaustrittsöffnung (2) ein Axial-Lüfter (4) angeordnet ist.

2. Heizvorrichtung nach Anspruch 1, **dadurch gekennzeichnet, dass** das Gehäuse (1) als an der Unterseite und zwei Schmalseiten offenes, U-förmiges Profilstück ausgebildet ist, auf dessen Oberseite (1.1) der Axial-Lüfter (4) angeordnet ist, während an einem Schenkel (1.2) des Profilstücks ein elektrischer Anschlußstecker (7) angeordnet ist.

3. Heizvorrichtung nach Anspruch 1 oder 2, **dadurch gekennzeichnet, dass** an der von der Oberseite des Gehäuses (1) abgewandten Oberfläche der Platte (3) des Kühlkörpers mindestens eine Widerstands-Heizfolie (5.1, 5.2) angeordnet ist.

4. Heizvorrichtung nach einem der Ansprüche 1 bis 3, **dadurch gekennzeichnet, dass** an der von der Oberseite (1.1) des Gehäuses (1) abgewandten Oberfläche der Platte (3) des Kühlkörpers mindestens ein temperaturgesteuertes Schaltelement (6.1, 6.2) angeordnet ist.

## Claims

1. Heating device for electronic components in military vehicles, especially combat tanks, having a flat housing (1) with an air inlet orifice in at least one of the narrow side walls and an air outlet orifice (2) at its upper part (1.1), whereby in the housing (1) there is arranged a metallic cooling body comprising a plate (3), which on its surface facing the upper part (1.1) of the housing (1) is provided with ribs or pins (3.1), whereas on the surface facing away from the upper part (1.1), it is in contact with at least one heating element (5.1, 5.2) and on the upper part (1.1) of the housing (1) an axial blower (4) is mounted in or before the air outlet orifice (2).

2. Heating device in accordance with Claim 1 above, **characterised in that** the housing (1) is in the form of a U-shaped piece, which is open at the bottom part and two narrow sides, on the surface of which the axial blower (4) is arranged, while an electrical plug (7) is mounted on a limb (1.2) of the said shaped piece

3. Heating device in accordance with Claim 1 or Claim 2 above, **characterised in that** at least one resistance heating foil (5.1, 5.2) is mounted on the surface of the plate (3) of the cooling body facing away from the upper part of the housing (1.1).

4. Heating device in accordance with Claims 1 to 3 above, **characterised in that** at least one temperature-regulated switch element (6.1, 6.2) is mounted on the surface of the plate (3) of the cooling body facing away from the upper part (1.1) of the housing (1).

## Revendications

1. Dispositif de chauffage pour des composants électroniques dans des véhicules militaires, en particulier des chars de combat, comportant un boîtier (1) plat avec une ouverture d'admission d'air dans au moins une des petites parois latérales et une ouverture d'échappement d'air (2) sur le côté supérieur (1.1), sachant que dans le boîtier (1) est disposé un corps de refroidissement métallique, formé par une plaque (3), qui est munie de nervures ou de broches (3.1) au niveau de sa surface orientée vers le côté supérieur (1.1) du boîtier (1), alors que, au niveau de la surface détournée du côté supérieur (1.1), elle est en contact avec au moins un élément chauffant (5.1, 5.2), et un ventilateur axial (4) est disposé sur le côté supérieur (1.1) du boîtier (1) dans ou en amont de l'ouverture d'échappement d'air (2).

2. Dispositif de chauffage selon la revendication 1, **caractérisé en ce que** le boîtier (1) est réalisé sous la forme d'une pièce profilée en forme de U, qui est ouverte sur le côté inférieur et sur deux petits côtés et sur le côté supérieur (1.1) de laquelle est disposé le ventilateur axial (4), tandis qu'une fiche de raccordement (7) électrique est disposée sur une branche (1.2) de la pièce profilée.

3. Dispositif de chauffage selon la revendication 1 ou 2, **caractérisé en ce qu'**au moins une feuille chauffante par effet Joule (5.1, 5.2) est disposée au niveau de la plaque (3) du corps de refroidissement sur la surface de celle-ci, détournée du côté supérieur du boîtier (1).

4. Dispositif de chauffage selon l'une quelconque des revendications 1 à 3, **caractérisé en ce qu'**au moins un élément de commutation (6.1, 6.2), commandé par la température, est disposé au niveau de la plaque (3) du corps de refroidissement sur la surface de celle-ci, détournée du côté supérieur (1.1) du boîtier (1).
